# EUROPÄISCHE PATENTANMELDUNG

(11) **EP 2 773 048 A1**
(43) Veröffentlichungstag der Anmeldung: **03.09.2014**
(21) Anmeldenummer: 14151100.6
(22) Anmeldetag: 14.01.2014
(51) Int. Cl.: H03M 13/03, H03M 13/15, H03M 13/31, H03M 5/00

(54) **Verfahren und Vorrichtung zur Anpassung von fehlerkorrigierenden Kanalkodes an den Leitungskode**

(30) Priorität: 28.02.2013 DE 102013203423
(71) Anmelder: Siemens Aktiengesellschaft, 80333 München (DE)
(72) Erfinder: Georgiades, Jean, 80805 München (DE); Wiesgickl, Bernhard, 92249 Vilseck (DE)

(57) **Zusammenfassung**

Es wird ein Verfahren zur Übertragung eines Datenpaketes vorgeschlagen. In einem ersten Schritt (301) werden in dem Leitungscode auftretende Fehlermuster ermittelt. In einem zweiten Schritt (302) wird eine Mehrzahl von fehlerkorrigierenden Kanalcodes zum Kodieren der Informationsbits des Datenpakets bestimmt. In einem dritten Schritt (303) werden die Bitpositionen der mittels eines jeweiligen Kanalcodes der Mehrzahl der Kanalcodes kodierten Bits in dem Datenpaket in Abhängigkeit von den ermittelten Fehlermustern bestimmt.

Hierdurch können die Fehlererkennung und die Fehlerkorrektur verbessert werden, wodurch sich die a priori erwartete Restfehlerwahrscheinlichkeit vermindert.

Ferner wird ein entsprechendes Computerprogrammprodukt sowie eine Vorrichtung zum Übertragen eines Datenpaketes vorgeschlagen.

## Beschreibung

Die vorliegende Erfindung betrifft ein Verfahren und eine Vorrichtung zum Übertragen eines Datenpaketes, bei welchem die Informationsbits mittels eines Leitungscodes codiert sind und diese mittels zumindest zwei fehlerkorrigierenden Kanalcodes gesichert sind.

Beispielsweise wird bei modernen Datenübertragungsverfahren orthogonales Frequenzmultiplexen (OFDM, Orthogonal Frequency Division Multiplexing) verwendet. Die zu übertragenden Datenbits werden hier üblicherweise in Symbolen zusammengefasst, wobei ein Symbol mindestens zwei Datenbits umfasst. Die Modulation/Demodulation der OFDM-Träger erfolgt üblicherweise über eine Phasenmodulation der einzelnen Träger. Hierbei wird häufig differentielle Phasenmodulation (DPSK, Different Phase Shift Keying) eingesetzt.

Bei diesem Verfahren ist die Information im Phasenunterschied des aktuellen Übertragungssymbols zum vorher übertragenen Symbol (Vorgängersymbol) beinhaltet. DPSK hat den Vorteil, dass keine Synchronisation über den gesamten Datenrahmen (Datenpaket) notwendig ist, sondern jeweils nur zwischen dem Vorgängersymbol und dem aktuellen Symbol. Ein Nachteil dieses Verfahrens besteht allerdings darin, dass bei einer Störung, zum Beispiel durch Rauschen oder eine elektromagnetische Störung, eines Symbols auch die Phasenlage des nachfolgenden Symbols falsch erkannt wird, da die Bezugsphase für die Detektion der Phasenlage des nachfolgenden Symbols falsch ist. Sind in einem Symbol zum Beispiel zwei Bits eincodiert, werden bei einer Störung dieses Symbols ein oder zwei Bits falsch decodiert und zwangsläufig sind beim nachfolgenden Symbol ein oder zwei Bits falsch. Das heißt, die Anzahl der Fehler verdoppelt sich.

Üblicherweise werden zur Datensicherung oder Fehlerkorrektur zusätzlich zu den Nutzdaten (Informationsbits) redundante Sicherungsbits (Redundanzbits) mit übertragen. Diese Redundanzbits erlauben, falsche Bits zu erkennen oder sogar zu korrigieren.

Umso mehr Fehler erkannt oder korrigiert werden sollen, umso mehr Redundanzbits sind notwendig, was die Effektivität der Datenübertragung reduziert.

Bei der Nutzung von fehlererkennenden oder fehlerkorrigierenden Codes, insbesondere mit maximaler Hamming-Distanz und minimaler Restfehlerwahrscheinlichkeit, um k Informationsbits mit n-k Redundanzbits zu schützen (siehe [2]), ist es zumeist richtig, dass ein (n,k)-Code C besser geeignet ist als eine Aufspaltung der Informations- und Redundanzbits in zwei Codes C1, C2, und zwar in einen (n1,k1)-Code C1 und einen (n2,k2)-Code C2, mit n1+n2=n und k1+k2=k (siehe [1]).

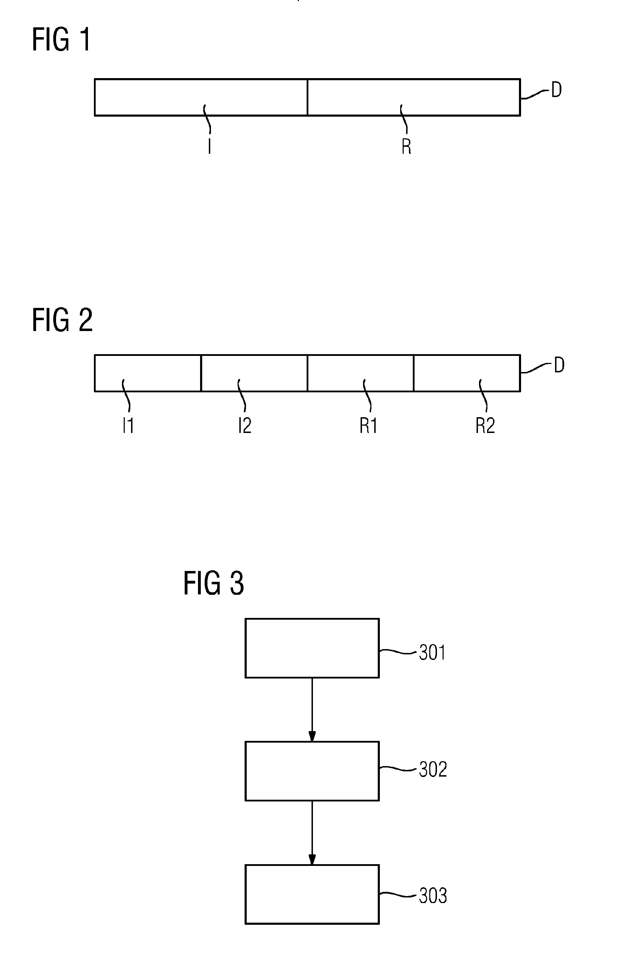

Hierzu zeigt die Fig. 1 einen typischen Aufbau eines Datenpakets D, welches durch einen fehlererkennenden bzw. fehlerkorrigierenden Code C gesichert ist. Der erste Teil I des Datenpakets D enthält den Informationsteil mit k Bits und der zweite Teil R des Datenpakets D enthält den Redundanzteil mit n-k Bits.

Ferner zeigt Fig. 2 einen typischen Aufbau eines Datenpaketes D für den Fall der Anwendung von zwei Codes C1 und C2 und der Aufspaltung des Informationsteils in zwei Gruppen, 11 und 12 der Länge k1 und k2 Bits (k1+k2=k), wobei der erste Teil 11 durch den Redundanzteil R1 (n1-k1 Bits) und der zweite Teil 12 durch den Redundanzteil R2 (n2-k2 Bits) gesichert wird.

Der Informationsteil I1, I2 ist in beiden Datenpaketen D gemäß der Fig. 1 und 2 identisch. Der Redundanzteil ist jedoch in beiden Datenpaketen unterschiedlich, da verschiedene Codes (C;C1,C2) eingesetzt sind.

Demnach ist es eine Aufgabe der vorliegenden Erfindung, ein verbessertes Verfahren zum Übertragen eines Datenpaketes vorzuschlagen, welches mittels zumindest eines fehlerkorrigierenden Kanalcodes gesichert ist.

Demgemäß wird ein Verfahren zum Übertragen eines Datenpaketes aus n Bits mit k mittels eines Leitungscodes codierten Informationsbits und n-k Redundanzbits vorgeschlagen. In einem ersten Schritt werden in dem Leitungscode auftretende Fehlermuster ermittelt. In einem zweiten Schritt wird eine Mehrzahl von fehlerkorrigierenden Kanalcodes zum Codieren des Datenpakets bestimmt. In einem dritten Schritt werden die Bitpositionen der mittels eines jeweiligen Kanalcodes der Mehrzahl der Kanalcodes zu codierenden Bits in dem Datenpaket in Abhängigkeit von den ermittelten Fehlermustern bestimmt.

Bei N bestimmten fehlerkorrigierenden Kanalcodes zum Codieren des Datenpaketes werden die Bitpositionen des Datenpakets in N Gruppen von Bitpositionen verteilt. Die Bits der jeweiligen Gruppe werden von genau einem fehlerkorrigierenden Kanalcode der N fehlerkorrigierenden Kanalcodes codiert. Folglich ist die Zuordnung Gruppe zu fehlercodierender Kanalcode eindeutig. Die jeweilige Gruppe von Bitpositionen kann auch als Sicherungsbereich des der Gruppe zugeordneten fehlerkorrigierenden Kanalcodes bezeichnet werden. Die Anmelderin hat festgestellt, dass bei Leitungscodes bestimmte Fehlermuster auftreten, das heißt wenn ein bestimmtes Bit umkippt, wird ein nachfolgendes Bit in einem bestimmten Bereich umkippen. Diese Kausalität des Umkippens bildet das Fehlermuster aus.

Folglich kann über die bestimmten Fehlermuster die Verteilung von Bitübertragungsfehlern in einem Übertragungskanal ermittelt werden. Die Ausnutzung dieser Information hinsichtlich der Verteilung von Bitübertragungsfehlern kann zur Bestimmung der Sicherungsbereiche genutzt werden, so dass sich zu erwartende Bitfehler auf die Sicherungsbereiche verteilen, insbesondere gleichmäßig verteilen. Durch die Verteilung der Bitfehler auf die Sicherungsbereiche werden die Wahrscheinlichkeiten für die Fehlererkennung und für die Fehlerkorrektur erhöht. Dadurch wird auch die a priori erwartete Restfehlerwahrscheinlichkeit vermindert.

Insgesamt kann durch die ermittelten Fehlermuster oder Bitfehlermuster die Gesamtzahl der auftretenden Fehler in zumindest zwei unveränderten Bitgruppen des übertragenen Datenpakets verteilt, insbesondere gleichmäßig verteilt werden.

Hierdurch ergibt sich eine höhere Decodierungsrate, da mehr Fehlerkombinationen erkennbar und/oder korrigierbar sind. Des Weiteren ergibt sich daraus auch die oben erwähnte verminderte Restfehlerwahrscheinlichkeit, da man, insbesondere beim Einsatz von Tabellen der Syndrome der Fehlerkombinationen (siehe [3]), stets erkennen kann, welche Bitpositionen als fehlerhaft angezeigt sind. Dadurch ist feststellbar, ob die Fehlerpositionen an den zumindest zwei verwendeten Kanalcodes konsistent sind oder eher als Ergebnis von mehreren Störungen hervorgegangen sind.

Durch die Verteilung der zu erwartenden Fehler auf zumindest zwei Sicherungsbereiche von zumindest zwei Kanalcodes kann die Fehlerverdoppelung durch ein eingesetztes DPSK-Verfahren ohne eine Erhöhung der Anzahl von Redundanzbits kompensiert werden.

Bei einer Ausführungsform werden genau zwei fehlerkorrigierende Kanalcodes mit einem ersten fehlerkorrigierenden Kanalcode und einem zweiten fehlerkorrigierenden Kanalcode zum Codieren des Datenpakets bestimmt.

Diese Ausführungsform ist die einfachste Möglichkeit der Verteilung von zu erwartenden Bitfehlern auf Gruppen oder Sicherungsbereiche für zumindest zwei verwendete Kanalcodes.

Bei einer weiteren Ausführungsform umfasst der dritte Schritt:
Bestimmen von ersten Bitpositionen von k1 Informationsbits und n1-k1 Redundanzbits in dem Datenpaket für den ersten fehlerkorrigierenden Kanalcode und von zweiten Bitpositionen von k2 Informationsbits und n2-k2 Redundanzbits in dem Datenpaket für den zweiten fehlerkorrigierenden Kanalcode in Abhängigkeit von den ermittelten Fehlermustern, mit k1+k2=k und n1+n2=n.

Die ersten Bitpositionen bilden die Sicherungsbereiche des ersten Kanalcodes aus. Entsprechend bilden die zweiten Bitpositionen den Sicherungsbereich des zweiten Kanalcodes aus.

Dabei werden vorzugsweise die folgenden Schritte durchgeführt:
Konkatenieren der k1 Informationsbits in Abhängigkeit von den bestimmten ersten Bitpositionen,
Bestimmen der n1-k1 Redundanzbits mittels der k1 Informationsbits und des Generatorpolynoms des ersten fehlerkorrigierenden Kanalcodes, und
Setzen der codierten k1 Informationsbits und der codierten n1-k1 Redundanzbits an die bestimmten ersten Bitpositionen in dem Datenpaket.

Ferner werden vorzugsweise die folgenden Schritte durchgeführt:
Konkatenieren der k2 Informationsbits und der n2-k2 Redundanzbits in Abhängigkeit von den bestimmten zweiten Bitpositionen,
Bestimmen der n2-k2 Redundanzbits mittels der k2 Informationsbits und des Generatorpolynoms des zweiten fehlerkorrigierenden Kanalcodes,
Setzen der codierten k2 Informationsbits und der codierten n2-k2 Redundanzbits an die bestimmten zweiten Bitpositionen in dem Datenpaket.

Bei einer weiteren Ausführungsform werden der Leitungscode, die Mehrzahl der fehlerkorrigierenden Kanalcodes und die bestimmten Bitpositionen der mittels des jeweiligen Kanalcodes zu codierenden Bits in dem Datenpaket zumindest einer Sendeeinrichtung und zumindest einer Empfangseinrichtung bereitgestellt.

Vor der Übertragung von Datenpaketen zwischen der Sendeeinrichtung und der Empfangseinrichtung werden die notwendigen Informationen hinsichtlich der Codierung und Decodierung ausgetauscht. Diese notwendigen Informationen umfassen insbesondere den verwendeten Leitungscode, die verwendeten fehlerkorrigierenden Kanalcodes und die bestimmten Bitpositionen, das heißt die Sicherungsbereiche der einzelnen verwendeten Kanalcodes.

Sowohl die Sendeeinrichtung als auch die Empfangseinrichtung kann als Sende-/Empfangseinrichtung ausgebildet sein.

Wenn ein Datenpaket von der Sendeeinrichtung an die Empfangseinrichtung übertragen wird, werden dann vorzugsweise folgende Schritte an der Empfangseinrichtung durchgeführt:
Konkatenieren der Bits an den bestimmten ersten Bitpositionen in dem übertragenen Datenpaket,
Decodieren der konkatenierten Bits der bestimmten ersten Bitpositionen mittels des Generatorpolynoms eines ersten Kanalcodes,
Setzen der decodierten Bits an die bestimmten ersten Bitpositionen in dem übertragenen Datenpaket,
Konkatenieren der Bits an den bestimmten zweiten Bitpositionen in dem übertragenen Datenpaket,
Decodieren der konkatenierten Bits der bestimmten zweiten Bitpositionen mittels des Generatorpolynoms eines zweiten Kanalcodes, und
Setzen der decodierten Bits an die bestimmten zweiten Bitpositionen in dem übertragenen Datenpaket.

Für das Bespiel von genau zwei verwendeten Kanalcodes kann obiges durch folgende Schritte an der Empfangseinrichtung präzisiert werden:
Konkatenieren der k1 Informationsbits und der n1-k1 Redundanzbits an den bestimmten ersten Bitpositionen in dem übertragenen Datenpaket,
Decodieren der konkatenierten k1 Informationsbits und der n1-k1 Redundanzbits der bestimmten ersten Bitpositionen mittels des Generatorpolynoms des ersten Kanalcodes,
Setzen der decodierten k1 Informationsbits und der n1-k1 Redundanzbits an die bestimmten ersten Bitpositionen in dem übertragenen Datenpaket,
Konkatenieren der k2 Informationsbits und der n2-k2 Redundanzbits an den bestimmten zweiten Bitpositionen in dem übertragenen Datenpaket,
Decodieren der konkatenierten k2 Informationsbits und der n2-k2 Redundanzbits der bestimmten zweiten Bitpositionen mittels des Generatorpolynoms des zweiten Kanalcodes, und
Setzen der decodierten k2 Informationsbits und der n2-k2 Redundanzbits an die bestimmten ersten Bitpositionen in dem übertragenen Datenpaket.

Bei einer weiteren Ausführungsform wird ein Orthogonales Frequenzmultiplexverfahren (OFDM, Orthogonal Frequency-Division Multiplexing) zum Übertragen des Datenpaketes von der Sendeeinrichtung an die Empfangseinrichtung verwendet.

OFDM ist ein hierfür besonders geeignetes Übertragungsverfahren zur Ausnutzung der vorliegenden Möglichkeit der Verteilung von erwarteten Bitfehlern auf zumindest zwei Gruppen.

Bei einer weiteren Ausführungsform wird als Leitungscode ein Gray-Code verwendet. Der Gray-Code ist ein stetiger Code, bei dem sich benachbarte Codewörter nur in einer einzigen dualen Ziffer unterscheiden. Die Hamming-Distanz aller benachbarten Codewörter ist somit 1. Dadurch verringert sich der maximal mögliche Ablesefehler bei der Quantisierung aus einem Analogsignal auf einen Code. Der Gray-Code wird hier insbesondere als Binärcode verwendet.

Bei einer weiteren Ausführungsform werden als fehlerkorrigierenden Kanalcodes lineare, zyklische Codes verwendet. Insbesondere sind alle linearen Codes verwendbar, die von einem Generatorpolynom erzeugt werden.

Bei einer weiteren Ausführungsform sind die fehlerkorrigierenden Kanalcodes Bose-Chaudhuri-Hocquenghem-Codes (BCH-Codes) oder Cyclic-Redundancy-Check-Codes (CRC-Codes).

Die BCH-Codes sind zyklische fehlerkorrigierende Codes.

Weiterhin wird ein Computerprogrammprodukt vorgeschlagen, welches auf einer programmgesteuerten Einrichtung die Durchführung des wie oben erläuterten Verfahrens veranlasst.

Ein Computerprogrammprodukt wie ein Computerprogramm-Mittel kann beispielsweise als Speichermedium, wie Speicherkarte, USB-Stick, CD-ROM, DVD oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Außerdem wird ein Datenträger mit einem gespeicherten Computerprogramm mit Befehlen vorgeschlagen, welche die Durchführung des wie oben erläuterten Verfahrens auf einer programmgesteuerten Einrichtung veranlassen.

Des Weiteren wird eine Vorrichtung zum Übertragen eines Datenpaketes aus n Bits mit k mittels eines Leitungscodes codierten Informationsbits und n-k Redundanzbits vorgeschlagen. Die Vorrichtung weist eine erste Einheit, eine zweite Einheit und eine dritte Einheit auf. Die erste Einheit ist zum Ermitteln von in dem Leitungscode auftretenden Fehlermustern eingerichtet. Die zweite Einheit ist zum Bestimmen einer Mehrzahl von fehlerkorrigierenden Kanalcodes zum Codieren des Datenpakets eingerichtet. Ferner ist die dritte Einheit zum Bestimmen von Bitpositionen der mittels eines jeweiligen Kanalcodes der Mehrzahl der Kanalcodes zu codierenden Bits in dem Datenpaket in Abhängigkeit von den ermittelten Fehlermustern eingerichtet.

Bei einem System zur Übertragung von Datenpaketen zwischen einer Mehrzahl von Sende-/Empfangseinheiten kann eine jede der Sende-/Empfangseinheiten mit einer wie oben beschriebenen Vorrichtung ausgestattet sein. Somit können die Datenpakete zwischen den Sende-/Empfangseinheiten mittels des oben beschriebenen Codierverfahrens übertragen werden.

Die jeweilige Einheit kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Dabei zeigen:
- Fig. 1: einen typischen Aufbau eines Datenpakets, welches durch einen fehlerkorrigierenden Code gesichert ist;
- Fig. 2: einen typischen Aufbau eines Datenpaketes für den Fall der Anwendung von zwei fehlerkorrigierenden Codes;
- Fig. 3: ein Ablaufdiagramm eines ersten Ausführungsbeispiels eines Verfahrens zum Übertragen eines Datenpaketes aus n Bits mit k mittels eines Leitungscodes codierten Informationsbits und n-k Redundanzbits;
- Fig. 4: ein Ablaufdiagramm eines zweiten Ausführungsbeispiels eines Verfahrens zum Übertragen eines Datenpaketes aus n Bits mit k mittels eines Leitungscodes codierten Informationsbits und n-k Redundanzbits;
- Fig. 5: ein Ausführungsbeispiel eines Verfahrens zum Verarbeiten eines übertragenen Datenpakets an einer Empfangseinrichtung;
- Fig. 6: eine mögliche Reservierung des ersten Sicherungsbereichs für den ersten Kanalcode und des zweiten Sicherungsbereichs für den zweiten Kanalcode in einem Datenpaket;
- Fig. 7: die Konkatenierung der Bitpositionen des ersten Sicherungsbereichs für den ersten Kanalcode;
- Fig. 8: die codierten Informationsbits und Redundanzbits des ersten Sicherungsbereichs;
- Fig. 9: die codierten Informationsbits und die codierten Redundanzbits an die bestimmten ersten Bitpositionen in dem Datenpaket;
- Fig. 10: die Konkatenierung der Bitpositionen des zweiten Sicherungsbereichs für den zweiten Kanalcode;
- Fig. 11: die codierten Informationsbits und Redundanzbits des zweiten Sicherungsbereichs;
- Fig. 12: das fertige Datenpaket nach der Codierung gemäß Fig. 4;
- Fig. 13: das empfangene Datenpaket, welches an manchen Bitstellen Fehler enthalten kann;
- Fig. 14: die Konkatenierung der k1 Informationsbits und der n1-k1 Redundanzbits an den bestimmten ersten Bitpositionen in dem übertragenen Datenpaket;
- Fig. 15: die Konkatenierung der k2 Informationsbits und der n2-k2 Redundanzbits an den bestimmten zweiten Bitpositionen in dem übertragenen Datenpaket;
- Fig. 16: die decodierten k1 Informationsbits und die n1-k1 Redundanzbits der bestimmten ersten Bitpositionen;
- Fig. 17: die decodierten k2 Informationsbits und die n2-k2 Redundanzbits der bestimmten zweiten Bitpositionen;
- Fig. 18: das decodierte Datenpaket mit den Bereichen von Informationsbits;
- Fig. 19: ein Blockschaltbild eines Ausführungsbeispiels einer Vorrichtung zum Übertragen eines Datenpaketes aus n Bits mit k mittels eines Leitungscodes codierten Informationsbits und n-k Redundanzbits;
- Fig. 20: eine beispielhafte Aufteilung von Sicherungsbereichen in einem Datenpaket; und
- Fig. 21: eine beispielhafte Aufteilung von Sicherungsbereichen in einem Datenpaket.

In den Figuren sind gleiche oder funktionsgleiche Elemente mit denselben Bezugszeichen versehen worden, sofern nichts anderes angegeben ist.

In Fig. 3 ist ein Ablaufdiagramm eines Ausführungsbeispiels eines Verfahrens zum Übertragen eines Datenpaketes aus n Bits mit k mittels eines Leitungscodes codierten Informationsbits und n-k Redundanzbits dargestellt.

In Schritt 301 werden in dem Leitungscode auftretende Fehlermuster ermittelt.

Als Leitungscode wird beispielsweise ein Gray-Code verwendet. Bei dem Gray-Code ist bekannt, dass er bestimmte Fehlermuster aufweist. Das heißt, wenn bei einem bestimmten Bit ein Übertragungsfehler auftritt, ist bekannt, dass bei zumindest einem bestimmten nachfolgenden Bit auch ein Fehler auftritt. Dieses Auftreten von abhängigen Fehlern in dem Bitmuster eines empfangenen Datenpaketes kann als Fehlermuster bezeichnet werden.

In Schritt 302 wird eine Mehrzahl von fehlerkorrigierenden Kanalcodes zum Codieren des Datenpakets bestimmt.

Die verwendeten fehlerkorrigierenden Kanalcodes sind insbesondere lineare und zyklische Codes. Beispielsweise werden hierbei Bose-Chaudhuri-Hocquenghem-Codes (BCH-Codes) verwendet.

In Schritt 303 werden die Bitpositionen der mittels eines jeweiligen Kanalcodes der Mehrzahl der Kanalcodes zu codierenden Bits in dem Datenpaket in Abhängigkeit von den ermittelten Fehlermustern bestimmt.

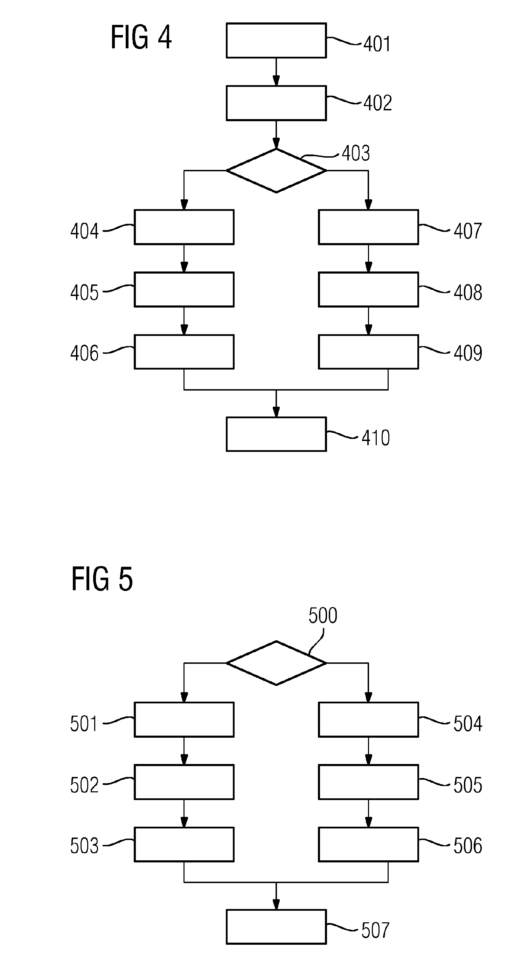

Fig. 4 zeigt ein Ablaufdiagramm eines zweiten Ausführungsbeispiels eines Verfahrens zum Übertragen eines Datenpaketes aus n Bits mit k mittels eines Leitungscodes codierten Informationsbits und n-k Redundanzbits.

In Schritt 401 werden die in den Leitungscodes auftretenden Fehlermuster ermittelt.

In Schritt 402 werden ein erster fehlererkennender Kanalcode und ein zweiter fehlererkennender Kanalcode zum Codieren des Datenpaketes bestimmt.

In Schritt 403 werden erste Bitpositionen von k1 Informationsbits und n1-k1 Redundanzbits in dem Datenpaket für den ersten fehlerkorrigierenden Kanalcode und zweite Bitpositionen von k2 Informationsbits und n2-k2 Redundanzbits in dem Datenpaket für den zweiten fehlerkorrigierenden Kanalcode in Abhängigkeit von den ermittelten Fehlermustern bestimmt (k=k1+k2, n=n1+n2).

Die ersten Bitpositionen in dem Datenpaket bestimmen eine erste Gruppe von Bitmustern. Entsprechend bestimmen die zweiten Bitpositionen in dem Datenpaket eine zweite Gruppe von Bitpositionen. Die Bits der jeweiligen Gruppe werden von genau einem fehlerkorrigierenden Kanalcode codiert. Dabei werden die Bits der ersten Gruppe von dem ersten Kanalcode codiert, wohingegen die Bits der zweiten Gruppe von dem zweiten Kanalcode codiert werden. Die jeweilige Gruppe von Bitpositionen kann auch als Sicherungsbereich des der Gruppe zugeordneten Kanalcodes bezeichnet werden.

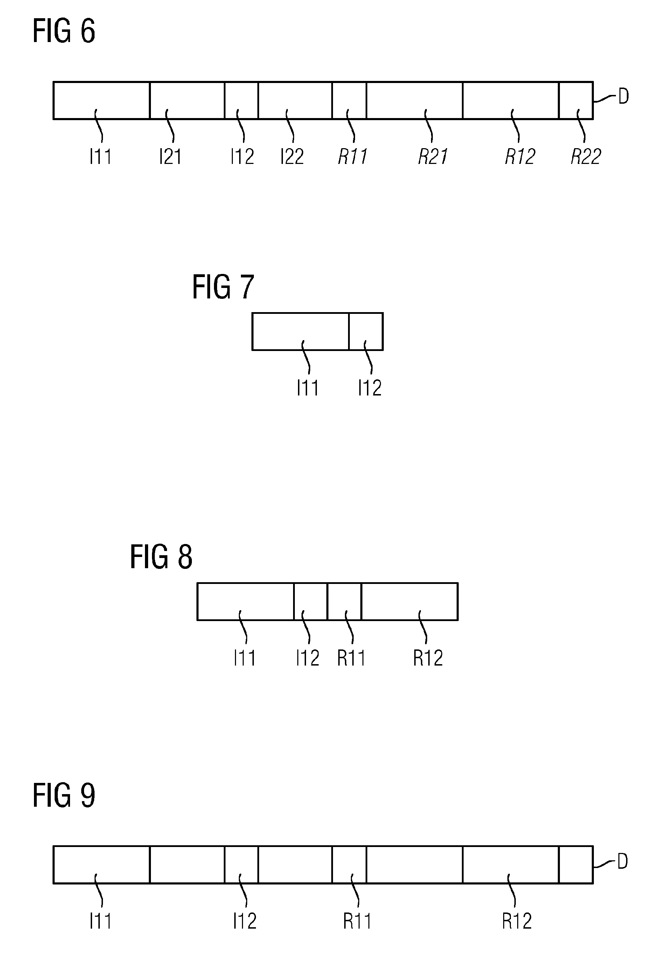

Hierzu zeigt die Fig. 6 eine mögliche Reservierung des ersten Sicherungsbereichs für den ersten Kanalcode und des zweiten Sicherungsbereichs für den zweiten Kanalcode in einem beispielhaften Datenpaket. In der Fig. 6 stehen die Informationsbits in den Bereichen I11, 112, I21 und 122 fest. Dies ist in der Fig. 6 durch Blockschrift gekennzeichnet. Im Gegensatz hierzu sind die Redundanzbits in den Bereichen R11, R12, R21 und R22 noch zu berechnen. Dies ist durch eine kursive Schrift in der Fig. 6 illustriert. Die Bereiche I11, 112, R11 und R12 gehören zum ersten Sicherungsbereich des ersten Kanalcodes, wohingegen die Bereiche 121, 122, R21 und R22 zum zweiten Sicherungsbereich des zweiten Kanalcodes gehören.

Nach Schritt 403 teilt sich das Verfahren der Fig. 4 dahingehend, dass die Schritte 404-406 für die ersten Bitpositionen und damit für die erste Gruppe (erster Sicherungsbereich) des ersten Kanalcodes durchgeführt werden, wohingegen die Schritte 407-409 für die zweiten Bitpositionen und damit die zweite Gruppe (zweiter Sicherungsbereich) des zweiten Kanalcodes durchgeführt werden.

In Schritt 404 werden die k1 Informationsbits in Abhängigkeit von den bestimmten ersten Bitpositionen konkateniert, das heißt hintereinander angeordnet. Dazu zeigt Fig. 7 die Konkatenierung der Bitpositionen I11 und I12 des ersten Sicherungsbereichs für den ersten Kanalcode C1.

In Schritt 405 werden die n1-k1 Redundanzbits (R11, R12) mittels der k1 Informationsbits und des Generatorpolynoms des ersten fehlerkorrigierenden Kanalcodes bestimmt. Die codierten k1 Informationsbits und n1-k1 Redundanzbits sind in der Fig. 8 dargestellt. Dabei sicheren die Bereiche R11 und R12 zusammen die Bereiche I11 und 112.

In Schritt 406 werden die codierten k1 Informationsbits und die codierten n1-k1 Redundanzbits an die bestimmten ersten Bitpositionen in dem Datenpaket gesetzt. Dies ist in Fig. 9 dargestellt. Die in dem Datenpaket der Fig. 9 leer dargestellten Bereiche sind für die k2 Informationsbits und für die n2-k2 Redundanzbits des zweiten fehlerkorrigierenden Kanalcodes C2 reserviert.

Die Füllung dieser leeren Bereiche wird im Folgenden mit Bezug zu den Schritten 407-409 erläutert.

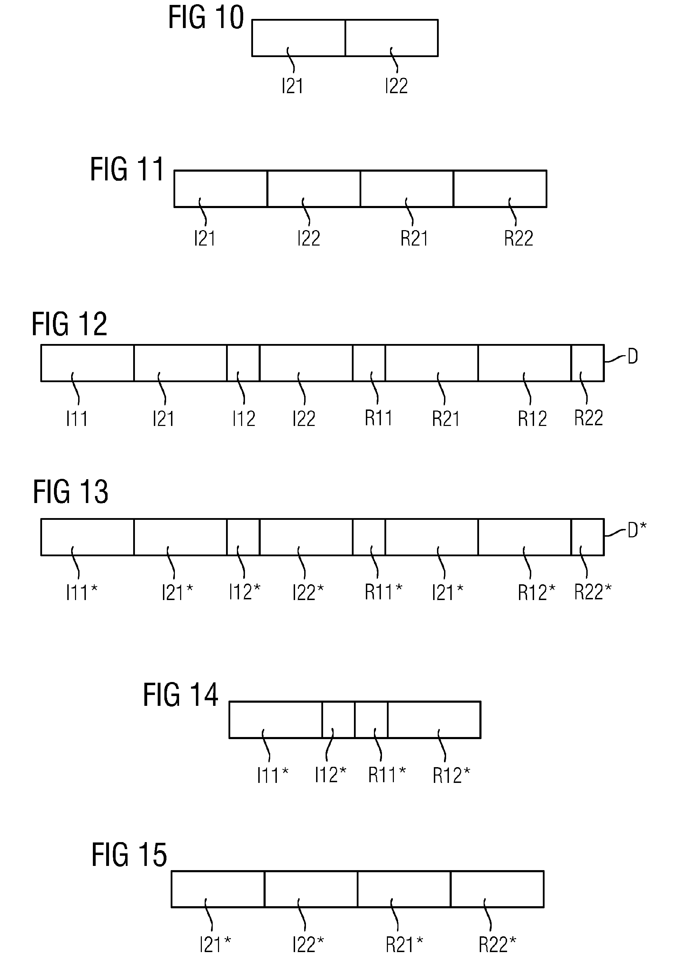

In Schritt 407 werden die k2 Informationsbits in Abhängigkeit von den bestimmten zweiten Bitpositionen konkateniert. Folglich sind die Bereiche I21 und 122 aneinander gereiht (siehe Fig. 10).

In Schritt 408 werden die n2-k2 Redundanzbits (R21, R22) mittels der k2 Informationsbits (121, 122) und des Generatorpolynoms des zweiten fehlerkorrigierenden Kanalcodes bestimmt (siehe Fig. 11).

In Schritt 409 werden die codierten k2 Informationsbits (121, 122) und die codierten n2-k2 Redundanzbits (R21, R22) an die bestimmten zweiten Bitpositionen in dem Datenpaket gesetzt (siehe leere Bereiche in Fig. 9).

Nach diesen Schritten ergibt sich das fertige Datenpaket gemäß der Fig. 12.

In Schritt 410 kann das fertige Datenpaket gemäß der Fig. 12 dann an eine Empfangseinrichtung übertragen werden.

Hierzu zeigt die Fig. 5 ein Ausführungsbeispiel eines Verfahrens zum Verarbeiten eines übertragenen Datenpakets an einer Empfangseinrichtung. Voraussetzung für ein korrektes Verarbeiten eines übertragenen Datenpaketes ist, dass der von der Sendeeinrichtung verwendete Leitungscode, die Mehrzahl der verwendeten fehlerkorrigierenden Kanalcodes und die bestimmten ersten und zweiten Bitpositionen sowohl der Sendeeinrichtung als auch der Empfangseinrichtung vor der Übertragung der Datenpakete bereitstellt sind.

In Schritt 500 wird ein übertragenes Datenpaket von der Empfangseinrichtung empfangen. Die Empfangseinrichtung kennt die ersten Bitpositionen (erster Sicherungsbereich des ersten Kanalcodes C1) und die zweiten Bitpositionen (Sicherungsbereiche des zweiten Kanalcodes) und filtert das übertragene Datenpaket entsprechend. Für die ersten Bitpositionen und damit den ersten Sicherungsbereich des ersten Kanalcodes C1 werden die Schritte 501-503 durchgeführt, wohingegen für die zweiten Bitpositionen und damit für den zweiten Sicherungsbereich des zweiten Kanalcodes die Schritte 504-506 durchgeführt werden.

Fig. 13 zeigt hierzu das empfangene Datenpaket D, welches eventuell an manchen Bitstellen auch Fehler enthalten kann. Aus diesem Grund sind die Bereiche des übertragenen Datenpakets mit Sternchen gekennzeichnet. Ansonsten entspricht das übertragene Datenpaket D der Fig. 13 dem gesendeten Datenpaket D der Fig. 12.

In Schritt 501 werden die k1 Informationsbits (I11*, I12*) und die n1-k1 Redundanzbits (R11*, R12*) an den bestimmten ersten Bitpositionen (erster Sicherungsbereich des ersten Kanalcodes C1) in dem übertragenen Datenpaket konkateniert (siehe Fig. 14). Entsprechend werden in Schritt 504 die k2 Informationsbits (I21*, I22*) und die n2-k2 Redundanzbits (R21*, R22*) an den bestimmten zweiten Bitpositionen (zweiter Sicherungsbereich des zweiten Kanalcodes C2) in dem übertragenen Datenpaket konkateniert (siehe Fig. 15).

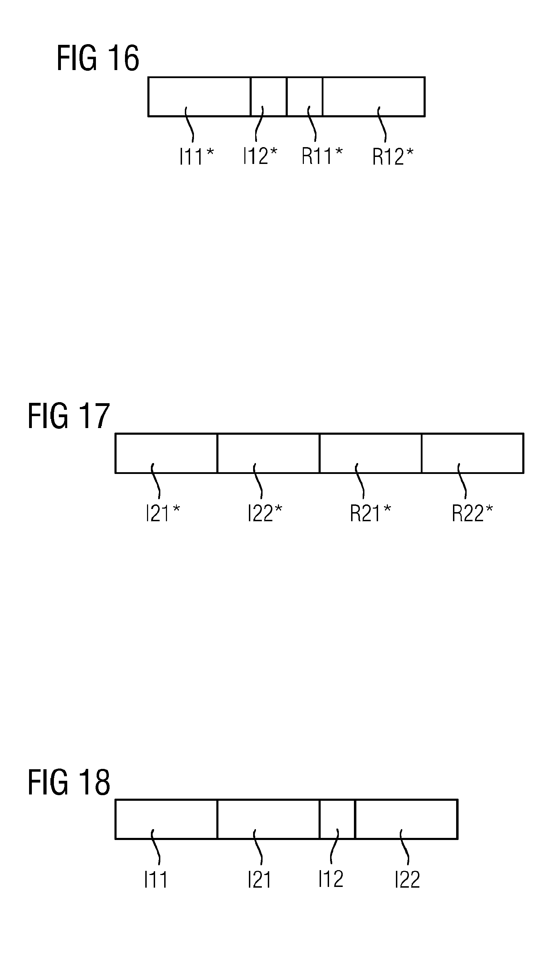

In Schritt 502 werden die konkatenierten k1 Informationsbits und die n1-k1 Redundanzbits der bestimmten ersten Bitpositionen mittels des Generatorpolynoms des ersten Kanalcodes decodiert (siehe Fig. 16). Entsprechend werden in Schritt 505 die konkatenierten k2 Informationsbits und die n2-k2 Redundanzbits der bestimmten zweiten Bitpositionen mittels des Generatorpolynoms des zweiten Kanalcodes C2 decodiert (siehe Fig. 17 sowie [3]).

In Schritt 503 werden die decodierten k1 Informationsbits gemäß der bestimmten ersten Bitpositionen in dem übertragenen Datenpaket gesetzt. Entsprechend werden im Schritt 506 die decodierten k2 Informationsbits gemäß der bestimmten zweiten Bitpositionen in dem übertragenen Datenpaket gesetzt. Das Ergebnis der Schritte 503 und 506 ist das decodierte Datenpaket mit den Bereichen I11, 121, 112, 122 von Informationsbits gemäß der Fig. 18.

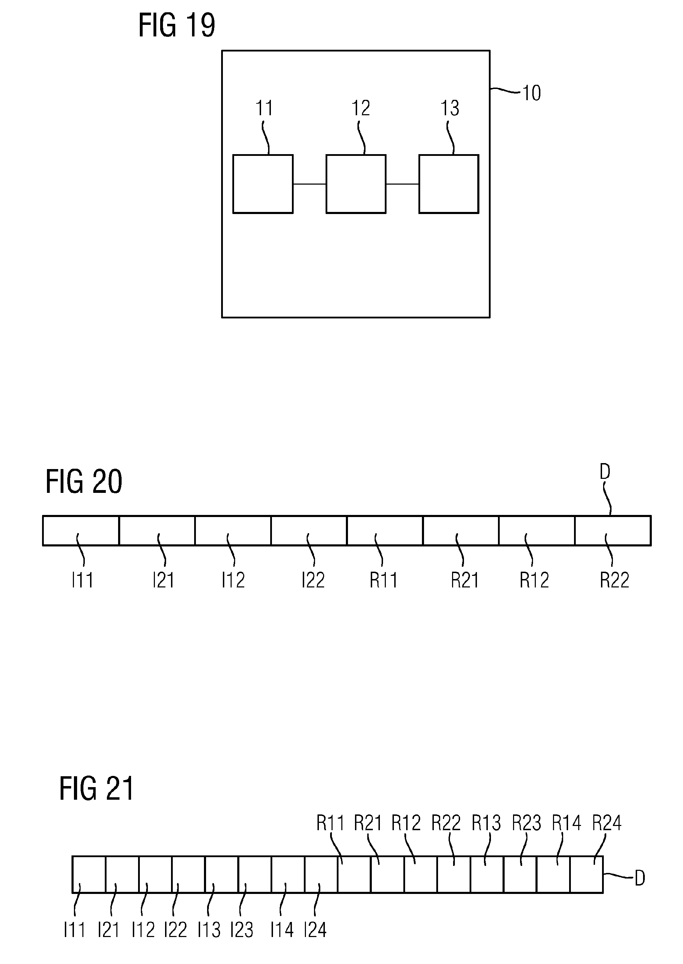

Fig. 19 zeigt ein Blockschaltbild eines Ausführungsbeispiels einer Vorrichtung 10 zum Übertragen eines Datenpaketes aus n Bits mit k mittels eines Leitungscodes codierten Informationsbits und n-k Redundanzbits. Die Vorrichtung 10 weist eine erste Einheit 11, eine zweite Einheit 12 und eine dritte Einheit 13 auf. Die erste Einheit 11 ist zum Ermitteln von in dem Leitungscode auftretenden Fehlermustern eingerichtet. Die zweite Einheit 12 ist zum Bestimmen einer Mehrzahl von fehlerkorrigierenden Kanalcodes zum Codieren des Datenpakets eingerichtet. Ferner ist die dritte Einheit 13 zum Bestimmen von Bitpositionen der mittels eines jeweiligen Kanalcodes der Mehrzahl der Kanalcodes zu codierenden Bits in dem Datenpaket in Abhängigkeit von den ermittelten Fehlermustern eingerichtet.

Die folgenden drei Beispiele zeigen konkrete Anwendungen der vorliegenden Codierung:

### Beispiel 1:

In diesem Beispiel 1 sei: n = 34, k = 18, n1=n2=17 und k1=k2=9.

Müsste man 18 Informationsbits mit 16 Redundanzbits schützen, so wäre es herkömmlich besser, einen (34,18)-Code C mit einer Hamming-Distanz 7 (Schreibweise: (34,18,7)) zu verwenden, anstatt zweier (17,9)-Codes C1 und C2 mit jeweils Hamming-Distanz 5 zu benutzen (Schreibweise: (17,9,5)). Der (34,18,7)-Code C hätte als rein fehlererkennender Code alle bis zu 6-Fehlerkombinationen erkannt, wohingegen die beiden anderen Codes C1 und C2 nicht einmal sicher alle 5-Fehlerkombinationen richtig erkannt hätten.

Der (34,18,7)-Code C, eingesetzt in seinem vollen Wirkungsradius als fehlerkorrigierender Code, würde alle bis zu 3-Fehlerkombinationen korrigieren können. Die Kombination der beiden anderen Codes C1 und C2 hätten nicht alle 3-Fehlerkombinationen korrigieren können, falls alle drei Fehler im Sicherungsbereich eines der beiden Codes C1 oder C2 gelegen hätten.

Allerdings verändert sich die Situation völlig, wenn die Aufspaltung der Menge der Informationsbits und Redundanzbits in zumindest zwei Gruppen durch die zusätzlichen Kenntnisse der in dem verwendeten Leitungscode auftretenden Fehlermuster so vorgenommen wird, dass es zumindest nahezu garantiert wird, dass die Anzahl der auftretenden Fehler gleichmäßig, insbesondere zumindest im Wesentlichen gleichmäßig, auf die beiden Bitgruppen verteilt ist. Wenn in obigem Beispiel der Benutzung der zwei (17,9,5)-Codes mit der Aussage, dass es nicht möglich ist, dass sich im Sicherungsbereich des einen Codes mehr als zwei Fehler mehr befinden als im Sicherungsbereich des anderen Codes, dann werden 3:0,4:0,4:1, 5:0,5:1, 5:2, 6:0, 6:1 und 7:0 Fehlerverteilungen ausgeschlossen.

Dann sind im Fall der Fehlererkennung sogar bis zu sieben Fehler erkennbar. Im Falle der Fehlerkorrektur sind dann 3-Fehlerkombinationen und die allermeisten der 4-Fehlerkombinationen korrigierbar. Folglich ist dann bei der vorliegenden geschickten Aufteilung der Informationsbits und Redundanzbits auf zumindest zwei Gruppen die Benutzung von zwei kürzeren Codes C1 und C2 anstatt eines längeren Codes vorteilhaft.

### Beispiel 2:

Das Beispiel 2 beschäftigt sich mit der Gray-Codierung von Symbolen. Mit dem Begriff "Symbol" sind dabei zwei Bits hintereinander bezeichnet, und zwar: das erste und zweite Bit einer Nachricht bilden das erste Symbol, das (2i-1)-te und das 2i-te Bit bilden das i-te Symbol.

Sind die Symbole einer Nachricht nach der Gray-Codierung interpretiert und passieren im Laufe der Übertragung 90° oder 270° Phasenstörungen, so kippt ein Bit im betroffenen Symbol um. Daraufhin kippt auch im darauffolgenden Symbol ein Bit um. Falls man die Informationsbits so aufteilt, dass benachbarte Symbole nicht dem Sicherungsbereich desselben Codes zugehören, dann kann garantiert werden, dass sich in den meisten Fällen die Anzahl der Fehler auf die beiden Codes gleichmäßig verteilen wird. Optimal für diesen Fall wäre es, wenn sowohl n als auch k durch 4 teilbar wären, dann könnten die zwei kürzeren Codes auch sowohl bei den Informationsbits als auch bei den Redundanzbits aus vollen Symbolen bestehen. Anderenfalls gäbe es bis zu zwei "gemischte" Symbole, bei denen das eine Bit im Sicherungsbereich des ersten Kanalcodes und das andere im Sicherungsbereich des zweiten Kanalcodes sind.

Die Sicherungsbereiche könnten dann wie folgt aussehen: Sicherungsbereich des ersten Kanalcodes = Bits: 1, 2, 5, 6, 9, 10, 13, 14, ...

Sicherungsbereich des zweiten Kanalcodes = Bits: 3, 4, 7, 8, 11, 12, 15, 16 ...

Dazu zeigt die Fig. 20 eine solche Aufteilung. Dabei bezeichnet I11 das erste Symbol (Bits 1 und 2), I21 bezeichnet das zweite Symbol (Bits 3 und 4), und so weiter. Die Bezeichnungen der Symbole sind dann wie folgt zu interpretieren:
I1x: Informationssymbole, welche von C1 gesichert werden
I2y: Informationssymbole, welche von C2 gesichert werden
R1z: Redundanzsymbole, welche von C1 gesichert werden
R2y: Redundanzsymbole, welche von C2 gesichert werden

### Beispiel 3:

Sollten in einem Übertragungskanal während der Übertragungen stets zwei benachbarte Bits umkippen, dann ist es sinnvoll, die Informationsbits und anschließend auch die Redundanzbits so zu gruppieren, dass die Bits mit einer ungeraden Position im Sicherungsbereich des ersten Codes und die Bits mit einer geraden Position im Sicherungsbereich des zweiten Codes sind. In den meisten Fällen würden sich dann die Fehler auf die beiden Sicherungsbereiche gleichmäßig verteilen.

Die Sicherungsbereiche könnten dann beispielsweise wie folgt aussehen:
Sicherungsbereich des ersten Codes = Bits: 1, 3, 5, 7, 9, 11, 13, 15, ...
Sicherungsbereich des zweiten Codes = Bits: 2, 4, 6, 8, 10, 12, 14, 16, ...

In der Fig. 21 ist eine solche Aufteilung dargestellt. Dabei bezeichnet I11 das erste Bit des Datenpakets, 121, das zweite Bit usw. Die Bezeichnungen der Bits sind wie folgt zu interpretieren:
I1x: Informationsbits, welche von C1 gesichert werden
I2y: Informationsbits, welche von C2 gesichert werden
R1z: Redundanzbits, welche von C1 gesichert werden
R2w: Redundanzbits, welche von C2 gesichert werden

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Sollten n1 = n2 und k1 = k2 sein, so wäre es denkbar, dass wenn zwei gleichgute Kanalodes C1 und C2 existieren, dass der Einsatz der zwei gleichguten Codes zur Verbesserung der Restfehlerwahrscheinlichkeit vorteilhaft wäre. Die zwei gleichguten Kanalodes C1 und C2 könnten zum Beispiel durch verschiedene Generatorpolynome generiert sein.

### Referenzen:

[1] P. Koopman, T. Chakravarty: Cyclic Redundancy Code (CRC) Polynomial Selection for Embedded Networks. DSN 2004
[2] Jørn Justesen, Tom Høholdt: A Course in Error-Correcting Codes, EMS Textbooks in Mathematics, 2004, ISBN-10: 3037190019, ISBN-13: 978-3037190012
[3] Decoding Methods in Wikipedia;
   http://en.wikipedia.org/wiki/Decoding_methods

## Patentansprüche

1. Verfahren zum Übertragen eines Datenpaketes (D) aus n Bits mit k mittels eines Leitungscodes codierten Informationsbits und n-k Redundanzbits, mit den Schritten:
a) Ermitteln (301,401) von in dem Leitungscode auftretenden Fehlermustern,
b) Bestimmen (302,402) einer Mehrzahl von fehlerkorrigierenden Kanalcodes zum Codieren des Datenpakets (D), und
c) Bestimmen (303,403) von Bitpositionen der mittels eines jeweiligen Kanalcodes der Mehrzahl der Kanalcodes zu codierenden Bits in dem Datenpaket (D) in Abhängigkeit von den ermittelten Fehlermustern.

2. Verfahren nach Anspruch 1,
**dadurch gekennzeichnet,**
**dass** zwei fehlerkorrigierende Kanalcodes mit einem ersten fehlerkorrigierenden Kanalcode und einem zweiten fehlerkorrigierenden Kanalcode zum Codieren des Datenpakets (D) bestimmt werden (402).

3. Verfahren nach Anspruch 2,
**dadurch gekennzeichnet,**
**dass** der Schritt c) umfasst:
Bestimmen (403) von ersten Bitpositionen von k1 Informationsbits (I11, I12) und n1-k1 Redundanzbits (R11,R12) in dem Datenpaket für den ersten fehlerkorrigierenden Kanalcode und
von zweiten Bitpositionen von k2 Informationsbits (I21,I22) und n2-k2 Redundanzbits (R21,R22) in dem Datenpaket (D) für den zweiten fehlerkorrigierenden Kanalcode in Abhängigkeit von den ermittelten Fehlermustern, mit k1+k2=k und n1+n2=n.

4. Verfahren nach Anspruch 3,
**gekennzeichnet durch**
Konkatenieren (404) der k1 Informationsbits (I11,I12) in Abhängigkeit von den bestimmten ersten Bitpositionen, Bestimmen (405) der n1-k1 Redundanzbits (R11,R12) mittels der k1 Informationsbits (I11,I12) und des Generatorpolynoms des ersten fehlerkorrigierenden Kanalcodes, und
Setzen (406) der codierten k1 Informationsbits (I11,I12) und der codierten n1-k1 Redundanzbits (R11,R12) an die bestimmten ersten Bitpositionen in dem Datenpaket (D).

5. Verfahren nach Anspruch 3 oder 4,
**gekennzeichnet durch**
Konkatenieren (407) der k2 Informationsbits in Abhängigkeit von den bestimmten zweiten Bitpositionen, Bestimmen (408) der n2-k2 Redundanzbits (R21,R22) mittels der k2 Informationsbits (I21,I22) und des Generatorpolynoms des zweiten fehlerkorrigierenden Kanalcodes, und
Setzen (409) der codierten k2 Informationsbits und der codierten n2-k2 Redundanzbits an die bestimmten zweiten Bitpositionen in dem Datenpaket (D).

6. Verfahren nach einem der Ansprüche 1 bis 5,
**dadurch gekennzeichnet,**
**dass** der Leitungscode, die Mehrzahl der fehlerkorrigierenden Kanalcodes und die bestimmten Bitpositionen der mittels des jeweiligen Kanalcodes zu codierenden Bits in dem Datenpaket (D) zumindest einer Sendeeinrichtung und zumindest einer Empfangseinrichtung bereitgestellt werden (500).

7. Verfahren nach Anspruch 6,
**dadurch gekennzeichnet,**
**dass** ein Datenpaket (D) von der Sendeeinrichtung an die Empfangseinrichtung übertragen wird und an der Empfangseinrichtung folgende Schritte durchgeführt werden:
Konkatenieren (501) der Bits an bestimmten ersten Bitpositionen in dem übertragenen Datenpaket (D*),
Decodieren (502) der konkatenierten Bits der bestimmten ersten Bitpositionen mittels des Generatorpolynoms eines ersten Kanalcodes,
Setzen (503) der decodierten Bits an die bestimmten ersten Bitpositionen in dem übertragenen Datenpaket (D*), Konkatenieren (504) der Bits an bestimmten zweiten Bitpositionen in dem übertragenen Datenpaket (D*),
Decodieren (505) der konkatenierten Bits der bestimmten zweiten Bitpositionen mittels des Generatorpolynoms eines zweiten Kanalcodes, und
Setzen (506) der decodierten Bits an die bestimmten zweiten Bitpositionen in dem übertragenen Datenpaket (D*).

8. Verfahren nach den Ansprüchen 5 und 6,
**dadurch gekennzeichnet,**
**dass** ein Datenpaket (D) von der Sendeeinrichtung an die Empfangseinrichtung übertragen wird und an der Empfangseinrichtung folgende Schritte durchgeführt werden:
Konkatenieren (501) der k1 Informationsbits und der n1-k1 Redundanzbits an den bestimmten ersten Bitpositionen in dem übertragenen Datenpaket (D*),
Decodieren (502) der konkatenierten k1 Informationsbits und
der n1-k1 Redundanzbits der bestimmten ersten Bitpositionen mittels des Generatorpolynoms des ersten Kanalcodes,
Setzen (503) der decodierten k1 Informationsbits gemäß der bestimmten ersten Bitpositionen in dem übertragenen Datenpaket (D*),
Konkatenieren (504) der k2 Informationsbits und der n2-k2 Redundanzbits an den bestimmten zweiten Bitpositionen in dem übertragenen Datenpaket (D*),
Decodieren (505) der konkatenierten k2 Informationsbits und
der n2-k2 Redundanzbits der bestimmten zweiten Bitpositionen mittels des Generatorpolynoms des zweiten Kanalcodes, und
Setzen (506) der decodierten k2 Informationsbits gemäß der bestimmten zweiten Bitpositionen in dem übertragenen Datenpaket (D*).

9. Verfahren nach Anspruch 7 oder 8,
**dadurch gekennzeichnet,**
**dass** ein Orthogonales Frequenzmultiplexverfahren zum Übertragen des Datenpaketes (D) von der Sendeeinrichtung an die Empfangseinrichtung verwendet wird.

10. Verfahren nach einem der Ansprüche 1 bis 9,
**dadurch gekennzeichnet,**
**dass** der Leitungscode ein Gray-Code ist.

11. Verfahren nach einem der Ansprüche 1 bis 10,
**dadurch gekennzeichnet,**
**dass** die fehlerkorrigierenden Kanalcodes lineare, zyklische Codes oder CRC-Codes sind.

12. Verfahren nach einem der Ansprüche 1 bis 10,
**dadurch gekennzeichnet,**
**dass** die fehlerkorrigierenden Kanalcodes Bose-Chaudhuri-Hocquenghem-Codes sind.

13. Computerprogrammprodukt, welches auf einer programmgesteuerten Einrichtung die Durchführung des Verfahrens nach einem der Ansprüche 1 bis 12 veranlasst.

14. Datenträger mit einem gespeicherten Computerprogramm mit Befehlen, welche die Durchführung des Verfahrens nach einem der Ansprüche 1 bis 12 auf einer programmgesteuerten Einrichtung veranlassen.

15. Vorrichtung (10) zum Übertragen eines Datenpaketes (D) aus n Bits mit k mittels eines Leitungscodes codierten Informationsbits und n-k Redundanzbits, mit:
einer ersten Einheit (11) zum Ermitteln von in dem Leitungscode auftretenden Fehlermustern,
einer zweiten Einheit (12) zum Bestimmen einer Mehrzahl von fehlerkorrigierenden Kanalcodes zum Codieren des Datenpakets (D), und
einer dritten Einheit (13) zum Bestimmen von Bitpositionen der mittels eines jeweiligen Kanalcodes der Mehrzahl der Kanalcodes zu codierenden Bits in dem Datenpaket (D) in Abhängigkeit von den ermittelten Fehlermustern.
